# EUROPEAN PATENT APPLICATION

(11) **EP 4 495 984 A1**
(43) Date of publication of application: **22.01.2025**
(21) Application number: 23186608.8
(22) Date of filing: 20.07.2023
(51) Int. Cl.: H01L 21/768, H01L 23/522

(54) **A METHOD FOR PRODUCING AN INTERCONNECT VIA**

(71) Applicant: IMEC VZW, 3001 Leuven (BE)
(72) Inventor: Gupta, Anshul, 3001 Leuven (BE); Tokei, Zsolt, 3000 Leuven (BE); Murdoch, Gayle, 3210 Lubbeek (BE); Decoster, Stefan, 3060 Bertem (BE); Park, Seongho, 3001 Leuven (BE)
(74) Representative: Patent Department IMEC

(57) **Abstract**

An electrically conductive layer (2) is produced on a substrate (1) having an upper surface formed of a dielectric material with electrical conductors or contacts embedded in said dielectric material. A dielectric layer (3) is then produced on the conductive layer (2). An opening (4) is formed in the dielectric layer (3) and subsequently filled with a conductive material to form a conductive via (6), after which the dielectric layer and the via are planarized to a common planar level. This is followed by the formation of at least one hardmask line (7a) which overlaps the via (6) so that a shoulder (6a,6b) of the via extends on each side of the hardmask line. The dielectric material and the conductive material of the via (6) and of the conductive layer (2) are then removed in the areas not covered by the hardmask line (7a), resulting in a conductive line (8a), having an interconnect via (10) on its top surface. The interconnect via is aligned to the width of the conductive line. The hardmask line (7a) is removed and a planar dielectric surface (12) is produced with the top of the interconnect via coplanar therewith.

## Description

### Field of the Invention

The present invention is related to semiconductor processing, in particular to the formation of interconnect vias between two levels of conductors of a multi-level interconnect structure of a semiconductor chip.

### State of the art.

Semiconductor-based integrated circuits continue to evolve towards smaller and smaller dimensions, leading to ongoing processing challenges. Multilayer conductive structures are typically built as layers of conductive lines, with interconnect vias formed between lines of the respective layers. As dimensions shrink, traditional lithography and etch processes are no longer able to ensure acceptable alignment between an interconnect via and the underlying line to which the via is connected.

A number of methods have been developed which enable self-alignment of a nano-sized interconnect via to the underlying conductive (usually metal) line. Patent publication document US2017256451 discloses a method wherein the metal lines of the lower level are formed by a patterning step using a hardmask in the form of a line array, and wherein the hardmask lines are maintained on the metal lines except at the via locations. At these locations, the hardmask is locally removed by lithography and selective etching to create a self-aligned via opening, which is subsequently filled by a damascene-type metal fill process. The hardmask lines are however reduced in size and/or oxidized after the metal line patterning, which can make it difficult to produce the via opening, especially at the deepest levels of a multi-level interconnect structure where the in-plane dimensions of the via opening may be in the order of a few nanometres.

Also, the remaining hardmask material is likely to increase the interlayer capacitance so there is an interest in using a hardmask material having low relative permittivity. These difficulties reduce the number of suitable choices for the hardmask material, as a material exhibiting low permittivity may not necessarily enable good etch selectivity.

### Summary of the invention

The invention aims to provide a solution to the problems indicated hereabove. This aim is achieved by a method according to the appended claims. The invention is thus related to a method for producing an interconnect via for connecting a lower conductive line to an upper conductive line overlying the lower line. Throughout this description and in the claims, the term 'conductive' is intended to refer to 'electrically conductive'.

The method is especially useful for the formation of interconnect vias which are nano-sized in three orthogonal directions, i.e. in terms of their width, length and height. The term 'nano-sized' in the present context is to be understood as: having at least one dimension of a few nanometres up to a few tens of nanometres. For example, a nano-sized conductive line is a line having a nano-sized width and height. A nano-sized interconnect via is a via having a nano-sized width, length and height.

According to the invention, a conductive layer is produced on a substrate having an upper surface formed of a dielectric material with electrical conductors or contacts embedded in said dielectric material. The substrate may for example be a process wafer whereon a FEOL portion and one or more layers of a BEOL portion have been produced according to a given layout for a number of integrated circuits arranged on the wafer. A dielectric layer is then produced on the conductive layer. An opening is formed in the dielectric layer and subsequently filled with a conductive material, after which the conductive material is planarized to the level of the dielectric material so that a conductive via is formed in the opening. This is followed by the formation of at least one hardmask line which overlaps the via so that a shoulder of the via extends on each side of the hardmask line. The dielectric material, the conductive material of the via, and of the conductive layer are then removed in the areas not covered by the hardmask line, resulting in a conductive line, having an interconnect via on its top surface. The interconnect via is formed by the removal of said shoulders of the original via, so that the interconnect via is aligned to the width of the conductive line. A second dielectric material is then produced and planarized to the top level of the hardmask line. The hardmask line and an upper portion of the second dielectric material are then removed (simultaneously or consecutively) so that a planar dielectric surface is produced with the top of the interconnect via coplanar therewith. The conductive lines of the next level of the interconnect structure can be formed on the planar surface.

According to preferred embodiments, a set of parallel conductive lines is formed with several self-aligned interconnect vias on one or more of said lines, said interconnect vias being produced in accordance with the method of the invention. In the latter case, said second dielectric material is deposited in the spaces between the lines. According to preferred embodiments, this is done in such a manner that airgaps are formed between adjacent lines.

The method of the invention differs from existing methods by the specific order of the steps: etching of the conductive lines of the lower level is done after the formation of an initial via on top of a blanket conductive layer. The initial via obtained by filling the opening becomes the interconnect via which is therefore self-aligned to the width of the underlying conductive line. The formation (including etching and cleaning steps) and filling of the opening for producing the initial via is easier because the width of the opening in the direction perpendicular to the conductive line is larger than said line width. This results in good via to underlying conductive line contact formation and thus, lower across-wafer nonuniformity, lower via resistance and superior reliability properties. One advantage in terms of the interlayer capacitance of the resulting multilevel interconnect structure is that the hardmask lines are removed after the formation of the interconnect via. In addition, inter-line airgaps can be extended to the level of the interconnect via thus providing significant further improvement in terms of capacitance.

The invention is in particular related to a method for producing an interconnect via for connecting a lower electrically conductive line in a first level of a multi-level interconnect structure to an upper electrically conductive line in a second level overlying said first level. The terms first level and second level refer to any two consecutive levels of the interconnect structure. The method comprises the steps of:
- providing a substrate having an upper surface formed of a dielectric material with electrical conductors or contacts embedded in said dielectric material,
- producing on said upper surface, a layer of a first conductive material and a dielectric layer formed of a first dielectric material, on the layer of the first conductive material,
- producing an opening in the dielectric layer, thereby exposing the first conductive material at the bottom of said opening,
- filling the opening with a second conductive material, which may or may not be the same as the first conductive material,
- planarizing the surface of the dielectric layer, thereby obtaining a conductive via embedded in the dielectric layer, wherein the upper surface of the via is coplanar with the upper surface of the dielectric layer, said upper surfaces forming a planarized surface,
- producing a hardmask layer on the planarized surface,
- patterning the hardmask layer so as to form a hardmask line, overlapping the upper surface of the via so that a shoulder of said via extends laterally on each side of said hardmask line),
- removing the dielectric layer and the first and second conductive material in the areas not covered by the hardmask line), thereby obtaining a conductive line, wherein an interconnect via is formed on said conductive line by removing said shoulders of the via, so that the width of the interconnect via is aligned to the width of said conductive line,
- producing a layer of a second dielectric material which may or may not be the same as the first dielectric material, wherein the second dielectric material envelops the hardmask line,
- planarizing the layer of the second dielectric material to the top level of the hardmask line,
- removing the hardmask line and an upper portion of the second dielectric material, thereby producing a planar surface formed of the second dielectric material, with said interconnect via embedded therein and having a top surface coplanar with said planar surface.

According to an embodiment, the hardmask line is one of an array of parallel lines.

According to an embodiment, the second dielectric material is deposited in such a manner that airgaps are created between adjacent conductive lines.

According to an embodiment, an airgap is formed on each side of the conductive line on top of which the interconnect via is formed, and said two airgaps have a top portion that overlaps a lower portion of the height of the interconnect via.

According to an embodiment, the height (H1) of said top portion of the two airgaps is at least 50% of the height of the interconnect via.

According to an embodiment, the interconnect via has nano-sized dimensions in three orthogonal directions.

According to an embodiment, the height of the interconnect via is between 10 nm and 30 nm.

According to an embodiment, the opening is filled by a bottom-up fill technique and wherein the step of planarizing the surface of the dielectric layer is done without a CMP (chemical mechanical polishing) step.

According to an embodiment, the first and second conductive material are chosen from the group consisting of Ru, W and Mo.

According to an embodiment, the first and second dielectric material is SiO₂ or a low-K material.

According to an embodiment, an adhesion layer is produced on the substrate prior to forming the layer of the first conductive material, and/or wherein an adhesion layer is produced on the layer of the first conductive material, prior to forming the dielectric layer.

### Brief description of the figures

Figures 1 to 9 illustrate key steps of the method according to an embodiment of the invention.
Figures 10 and 11 illustrate an embodiment wherein airgaps are created between adjacent conductive lines.
Figure 12 is a section view illustrating a more realistic appearance of the airgaps and relevant dimensions thereof in accordance with an embodiment of the invention.

### Detailed description of the invention

One embodiment of the method of the invention will now be described in detail. Any reference to material choices and dimensions is included by way of example only and does not limit the scope of the invention, which is defined only by the appended claims.

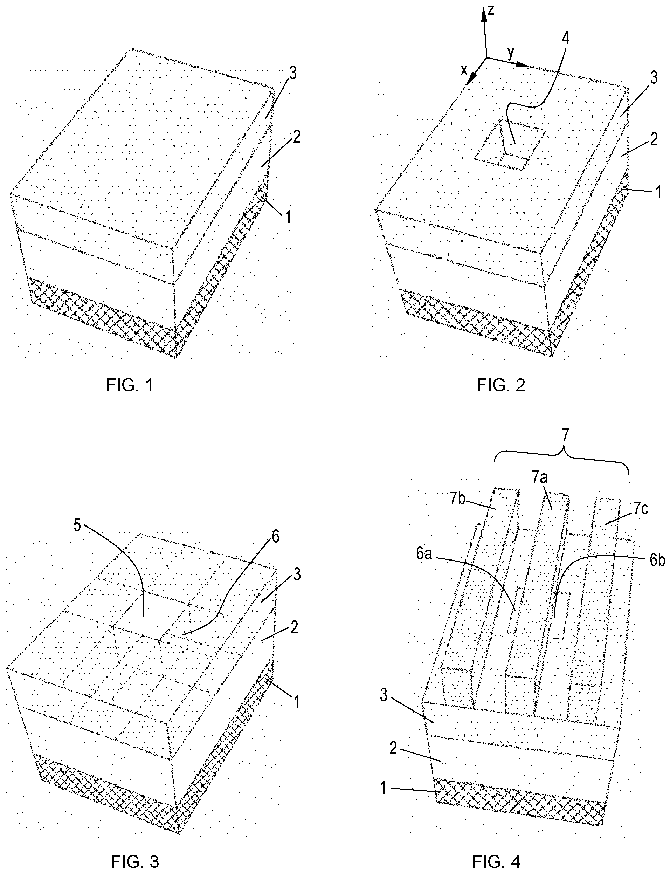

Figure 1 shows a small section of a substrate comprising a base portion 1 which may be a nano-sized upper slice of a silicon process wafer after the front end of line (FEOL) processing and part of the back end of line (BEOL) processing. As is known to the person skilled in the domain of semiconductor processing, the FEOL process constitutes a sequence of processing steps for producing large numbers of semiconductor devices such as transistors and diodes on usually a silicon wafer, according to the layout of several integrated circuit chips. BEOL processing adds a multi-level interconnect structure on top of the FEOL portion of the chips, said interconnect structure comprising multiple levels of electrically conductive lines, interconnected according to a predefined interconnection scheme by vertical interconnects, referred to in the present description as 'interconnect vias'. The interconnect levels are usually labelled Metal0, Metal1, Metal2, etc (in short M0, M1, M2, etc), as the line material is usually a metal such as Cu, W or Ru. The deepest level M0 includes connections in direct contact with the active devices in the FEOL and is also referred to as the Middle of Line portion (MOL) of an integrated circuit.

The top surface of the base portion 1 is formed of a dielectric material, for example SiO₂ or low-K dielectric onto which surface the conductive lines of an interconnect level Mi are to be formed. Embedded in said dielectric layer are electrical conductors or contacts, which may include conductive lines in level Mi-1 or interconnect vias intended to connect the lines of level Mx to the lines of level Mi-1, or connections to source or drain electrodes of transistors of the FEOL portion if level Mi-1 is the M0 level (MOL).

The method of the invention includes method steps for forming one or more lines of any level Mi and one or more interconnect vias towards the lines of level Mi+1 for i = 0, 1, 2, 3, ..

Two layers are produced on the top surface of the base portion 1, as illustrated in Figure 1. The first layer 2 is a conductive layer. For the deep levels of the BEOL (for example i = 1 to 3) this may for example be a layer of Ru, W or Mo. For some materials, such as for Ru, it may be required to provide an adhesion layer such as a thin TiN layer between the base substrate 1 and the Ru layer 2.

On top of the conductive layer 2, a layer 3 of dielectric material, for example SiO₂ or a low-K dielectric, is deposited. An adhesion layer may again be required between the conductive layer 2 and the dielectric layer 3, depending on the material of layer 2. The exemplary case is shown however wherein no adhesion layers are applied.

The thickness of the various layers depends on the metallization levels to which the method is applied, i.e. the value of i. The method of the invention is applicable down to the deepest levels and provides the most benefits at these levels given the importance of controlling the via alignment at the nano-sized dimensions applicable at these deep levels. For example, for i= 2 (production of interconnect vias between M2 and M3), the thickness of layer 2 may be in the order of 25 nm while the thickness of layer 3 may be in the order of 15 nm.

With reference to Figure 2, an opening 4 is now formed in the dielectric layer 3. In most cases and especially at the deeper levels, a plurality of such openings are formed simultaneously at various intended via locations across the wafer. The opening 4 is a cavity that is open to the surface of the dielectric layer 3. The opening 4 is represented as having a rectangular cross-section, but the opening may be shaped differently, for example having an ellipse-shaped or circular cross-section. For i=2, the lateral dimensions of the opening may for example be in the order of 18 nm in the x-direction and y-direction, with reference to the orthogonal axes included in Figure 2. A known way of producing openings of these dimensions is to a apply a hardmask formed of a stack of SOC (spin-on-carbon), SOG (spin-on-glass) and photoresist. The photoresist is patterned to form openings which are larger than the targeted dimensions and shrink technology is applied to arrive at the desired dimensions of the opening 4. Such shrink technology is known as such and details thereof are not required here. For larger values of i, i.e. at higher levels in the BEOL stack, a more straightforward lithography and etch process may be used as the lateral dimensions of the opening will be larger at those levels.

The bottom of the opening 4 is formed of the conductive material of layer 2. Therefore, if an adhesion layer is present between layer 2 and layer 3, the adhesion layer needs to be removed selectively with respect to the material of layer 2.

The opening 4 is then filled with a second conductive material, which may or may not be the same as the conductive material of layer 2. An additional conductive adhesion liner on the bottom of the opening 4 may be required before the opening is filled with the second material.

Filling the opening 4 may be done by a known technique such as CVD (Chemical Vapour Deposition) or ALD (Atomic Layer Deposition), which will result in a thick layer of the second conductive material on top of the dielectric layer 3. This layer is then removed by grinding and CMP (chemical mechanical polishing), until a planarized surface is obtained as shown in Figure 3: the planarized surface is formed of the dielectric material of layer 3, with an island 5 of conductive material coplanar therewith. The island 5 forms the top surface of a via 6 of conductive material that is in electrical contact with the underlying conductive layer 2. The via 6 is represented in Figure 3 with the help of a number of auxiliary lines which help to visualize the position of the via relative to layers 2 and 3.

Another way of filling the opening 4 is by a bottom-up fill technique (known as such) wherein the via 6 is built up from the bottom of the opening 4 and the via material is not deposited on the dielectric layer 3 until the opening is filled. This creates only a thin layer of the conductive material on the dielectric layer 3 that may be removed by a wet etch process and without applying CMP. This approach enables a better control of the height of the via 6.

With reference to Figure 4, a hardmask layer is then produced on the planarized surface and patterned according to a regular pattern of parallel lines 7 oriented in the x-direction and having essentially the same width and height.

The width of the lines 7 is smaller than the y-dimension of the island 5, for example the lines 7 may have a width and pitch of about 9 nm for i=2. As seen in the image, one line 7a is overlapping the via 6, so that lateral shoulders 6a and 6bof the via 6 extend on both sides of said line 7a without overlapping the adjacent lines 7b and 7c. Preferably and as illustrated, the lithography and etch steps applied for producing the lines 7 are configured to produce the line 7a concentrically with respect to said y-dimension of the via 6. However, an unavoidable overlay error of 1 or 2 nm may result in a slight deviation of this theoretical case. In any case, the lines 7 are formed in such a way that two shoulders 6a and 6b of the conductive via 6 are exposed on both sides of the hardmask line 7a.

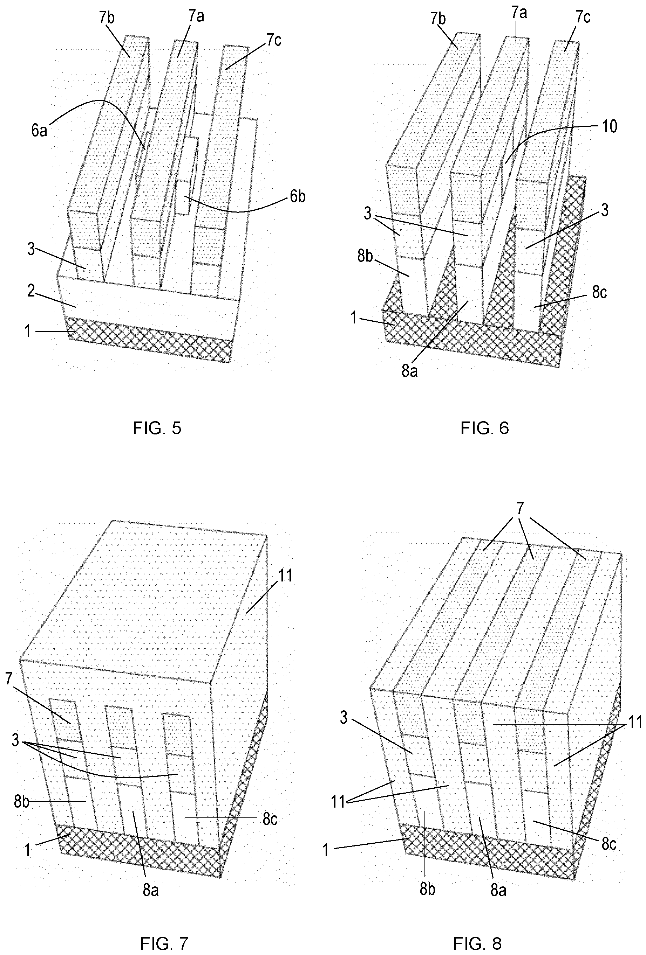

Then one or more etch steps are performed for transferring the hardmask line pattern to the underlying layers. The images shown in Figures 5 and 6 illustrate a 2-step process but depending on the applied materials and dimensions, a single step process may also be applicable. As seen in Figure 5, the dielectric layer 3 is removed selectively with respect to the conductive via 6, in the areas not covered by the hardmask lines 7, resulting in dielectric lines 3 on the conductive layer 2, and the exposure of the shoulders 6a and 6b of the via 6. In a second etch step illustrated in Figure 6, the conductive materials of the via 6 and of the underlying layer 2 are etched in the areas not covered by the hardmask lines 7, thereby creating parallel conductive lines 8a, 8b and 8c.

In the second etch step, the shoulders 6a and 6b of the conductive via 6 are removed. What remains of the initial via 6 is an interconnect via 10 that is aligned to the width of the underlying conductive line 8a. The dielectric line 3 on top of the conductive line 8a is interrupted by the interconnect via 10.

As the initial via 6 is formed prior to the formation of the conductive line 8a, the alignment of the interconnect via 10 to the y-dimension of the conductive line 8a is in fact a self-alignment: due to the nature of the production process, the interconnect via 10 is automatically aligned to the line 8a.

In the x-direction, the dimension of the interconnect via 10 is essentially the same as the x-dimension of the original via 6.

In Figures 5 and 6, the hardmask lines 7 are shown at their original thickness prior to the etch steps illustrated in these images, which represents the ideal case wherein the etch selectivity is about 100%. In reality the hardmask lines 7 may be reduced somewhat in thickness and/or become partially oxidized. These eventualities do not however influence the execution of the subsequent method steps according to the invention. Also, the invention is explained for embodiments wherein a set of parallel lines 7 is formed, which is almost always going to be the case especially at the deeper BEOL levels, but the invention is theoretically applicable to a single line 7a configured to form a single conductive line with a self-aligned interconnect via formed thereon.

The remainder of the method includes the removal of the hardmask lines 7 and the embedding of the interconnect via 10 in a dielectric layer ready to produce thereon the next interconnect level. Two alternative ways of realizing this are described with reference respectively to Figures 7-9 and 10-12.

With reference to Figure 7, a dielectric material 11 is produced on the obtained conductive lines 8a-8c and the interconnect via 10. According to a first embodiment illustrated in Figure 7, the dielectric material 11 is produced in such a way that it fills the spaces between the conductive lines 8a-8c completely and fully envelops the conductive lines 8a-8c, the dielectric lines 3 and the hardmask lines 7. The dielectric material 11 may or may not be the same material as the material of layer 3, for example SiO₂ or a low-K dielectric material.

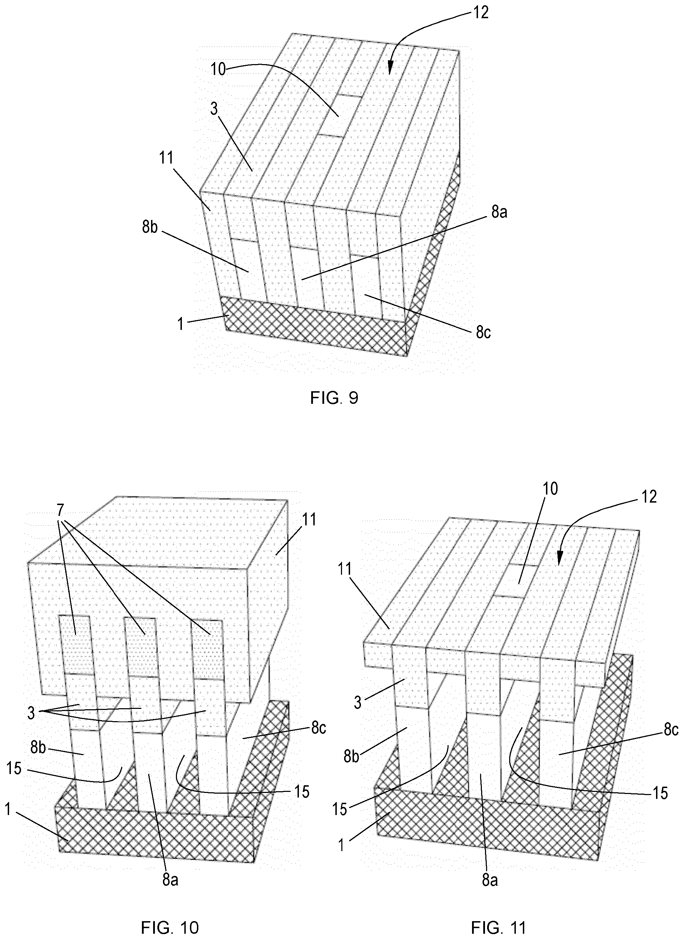

This is then followed by planarizing the top surface of the dielectric material 11 until the hardmask lines 7 are exposed, as shown in Figure 8, and by the removal of the hardmask lines 7 and of the dielectric material 11 between these hardmask lines, as shown in Figure 9. The latter step may be done by a cyclic dry etch process that removes both the dielectric 11 and the hardmask material 7. Preferably no CMP is used to arrive at the image shown in Figure 9. The hardmask material is completely removed, which is an advantage compared to a number of prior art methods, both in terms of the avoidance of the parasitic capacitance that may be caused by the hardmask material and in terms of the possibility of selecting the hardmask material only on the basis of etch-related characteristics, such as the etch selectivity relative to the materials of layers 2 and 3 and of the via 6, and the capability of simultaneously removing the hardmask lines 7 and the second dielectric material 11.

With reference to Figure 9, the result of the method of the invention is a dielectric surface 12 with the top surface of the interconnect via 10 coplanar therewith. This surface is ready to receive thereon a further conductive layer that is thereafter patterned to form the conductive lines of the next BEOL level Mi+1. For i=2, this is the M3 level. These M3 lines may be oriented in the y-direction and have a width in the order of the x-dimension of the interconnect via 10. The production of these M3 lines (or generally Mi+1 lines) can be realized according to known methods.

Figures 10 and 11 illustrate another embodiment, according to which the dielectric material 11 is deposited in such a manner that it does not completely fill the spaces between adjacent conductive lines 8a-8c. Instead of this, so-called airgaps 15 are formed. This is a known phenomenon, and methods of deliberately forming these airgaps are well-known in the prior art. After depositing the dielectric material 11 in this way, the planarization step and the removal of the hardmask lines 7 takes place in the same way as described above, resulting in the image shown in Figure 11.

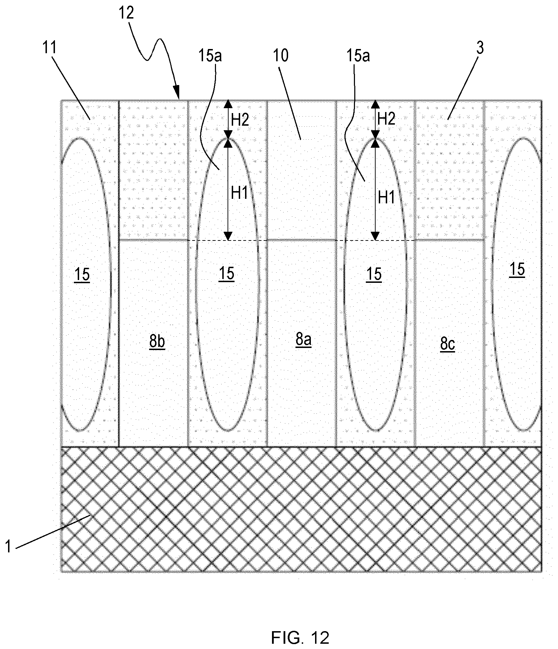

In Figures 10 and 11, the airgaps 15 are represented as though no dielectric material whatsoever is deposited beneath a given level in the z-direction, but this is merely a symbolic representation. In reality, some dielectric material is deposited on the sidewalls of the lines 8a-8c and on the substrate 1, while an air-filled cavity of more or less ellipse-shaped cross-section remains in the spaces between the conductive lines. This more realistic representation is illustrated in a section view in Figure 12.

It is known that the inclusion of airgaps between adjacent conductive lines reduces significantly the capacitance of the insulation material of the interconnect structure. The formation of airgaps in a structure wherein the interconnect vias are produced by a method according to the invention is particularly advantageous. This is because the particular order of the process step enables the creation of airgaps which are higher compared to other processing methods. This is illustrated in Figure 12 : the airgaps between adjacent lines 8a/8b and 8a/8c have a top portion 15a that is directly adjacent the interconnect via 10. This arrangement of the airgaps results in a significant reduction of the fringe capacitance between the via and neighbouring conductors in the interconnect structure. The overlap between the airgaps 15 and the interconnect via 10 is represented as the height H1 in Figure 12, with H2 representing the thickness of the remaining dielectric material above the airgap 15, and with H1 + H2 essentially corresponding to the height of the interconnect via 10. H2 is required to be large enough to ensure that the planarized surface 12 is homogenous. According to preferred embodiments, the via height is tuned to enable H1 to be as high as possible relative to the via height. The overlap height H1 is preferably at least 50% of the via height. For example, at i=2, H2 is preferably at least 5 nm, and the via height may be configured to be between 10 nm and 30nm, so that H1 can be 50% or up to 83% depending on the via height.

The invention is applicable in the production process of any multilevel interconnect structure, such as the BEOL portion of a semiconductor chip or the back side power delivery network of a chip.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

Unless specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate.

## Claims

1. A method for producing an interconnect via (10) for connecting a lower electrically conductive line (8a) in a first level of a multi-level interconnect structure to an upper electrically conductive line in a second level overlying said first level, the method comprising the steps of:
- providing a substrate (1) having an upper surface formed of a dielectric material with electrical conductors or contacts embedded in said dielectric material,
- producing on said upper surface, a layer (2) of a first conductive material and a dielectric layer (3) formed of a first dielectric material, on the layer (2) of the first conductive material,
- producing an opening (4) in the dielectric layer (3), thereby exposing the first conductive material at the bottom of said opening (4),
- filling the opening (4) with a second conductive material, which may or may not be the same as the first conductive material,
- planarizing the surface of the dielectric layer (3), thereby obtaining a conductive via (6) embedded in the dielectric layer (3), wherein the upper surface (5) of the via (6) is coplanar with the upper surface of the dielectric layer (3), said upper surfaces forming a planarized surface,
- producing a hardmask layer on the planarized surface,
- patterning the hardmask layer so as to form a hardmask line (7a), overlapping the upper surface (5) of the via (6) so that a shoulder (6a,6b) of said via (6) extends laterally on each side of said hardmask line (7a),
- removing the dielectric layer (3) and the first and second conductive material in the areas not covered by the hardmask line (7a), thereby obtaining a conductive line (8a), wherein an interconnect via (10) is formed on said conductive line by removing said shoulders of the via (6), so that the width of the interconnect via (10) is aligned to the width of said conductive line (8a),
- producing a layer (11) of a second dielectric material which may or may not be the same as the first dielectric material, wherein the second dielectric material envelops the hardmask line (7a),
- planarizing the layer (11) of the second dielectric material to the top level of the hardmask line (7a),
- removing the hardmask line (7a) and an upper portion of the second dielectric material, thereby producing a planar surface (12) formed of the second dielectric material, with said interconnect via (10) embedded therein and having a top surface coplanar with said planar surface (12).

2. The method according to claim 1, wherein the hardmask line (7a) is one of an array of parallel lines (7).

3. The method according to claim 2, wherein the second dielectric material is deposited in such a manner that airgaps (15) are created between adjacent conductive lines (8).

4. The method according to claim 3, wherein an airgap (15) is formed on each side of the conductive line (8a) on top of which the interconnect via (10) is formed, and wherein said two airgaps have a top portion (15a) that overlaps a lower portion of the height of the interconnect via (10).

5. The method according to claim 4, wherein the height (H1) of said top portion (15a) of the two airgaps is at least 50% of the height of the interconnect via (10).

6. The method according to any one of the preceding claims, wherein the interconnect via (10) has nano-sized dimensions in three orthogonal directions.

7. The method according to claim 6, wherein the height of the interconnect via (10) is between 10 nm and 30 nm.

8. The method according to any one of the preceding claims, wherein the opening (4) is filled by a bottom-up fill technique and wherein the step of planarizing the surface of the dielectric layer (3) is done without a CMP (chemical mechanical polishing) step.

9. The method according to any one of the preceding claims, wherein the first and second conductive material are chosen from the group consisting of Ru, W and Mo.

10. The method according to any one of the preceding claims wherein the first and second dielectric material is SiO₂ or a low-K material.

11. The method according to any one of the preceding claims, wherein an adhesion layer is produced on the substrate (1) prior to forming the layer (2) of the first conductive material, and/or wherein an adhesion layer is produced on the layer (2) of the first conductive material, prior to forming the dielectric layer (3).
